## Europäisches Patentamt
## European Patent Office
## Office européen des brevets

(19)

(11) Numéro de publication: **0 067 757**
**B1**

(12) **FASCICULE DE BREVET EUROPEEN**

(45) Date de publication du fascicule du brevet:
**16.10.85**

(51) Int. Cl.⁴: **H 05 K 7/14**

(21) Numéro de dépôt: **82401002.9**

(22) Date de dépôt: **01.06.82**

(54) Module électronique enfichable dans un connecteur de bus.

(30) Priorité: **03.06.81 FR 8111124**

(43) Date de publication de la demande:
**22.12.82 Bulletin 82/51**

(45) Mention de la délivrance du brevet:
**16.10.85 Bulletin 85/42**

(84) Etats contractants désignés:
**BE CH DE GB IT LI NL SE**

(56) Documents cités:
**FR - A - 2 207 404**
**FR - A - 2 412 224**
**US - A - 3 631 299**
**US - A - 3 729 657**

(73) Titulaire: **MERLIN GERIN, Rue Henri Tarze,**
**F-38050 Grenoble Cedex (FR)**

(72) Inventeur: **Andrighetto, Bernard, Merlin Gerin Rue Henri**
**Tarze, F-38050 Grenoble Cedex (FR)**
Inventeur: **Cun, Jean-Paul, Merlin Gerin Rue Henri Tarze,**
**F-38050 Grenoble Cedex (FR)**
Inventeur: **Hermil-Boudin, Alain, Merlin Gerin Rue Henri**
**Tarze, F-38050 Grenoble Cedex (FR)**

(74) Mandataire: **Kern, Paul et al, Merlin Gerin Sce.**
**Brevets 20, rue Henri Tarze, F-38050 Grenoble Cedex**
**(FR)**

## Description

L'invention est relative à un module électronique enfichable dans un connecteur fixe porté par une carte de liaison ou bus solidaire d'un socle support, ledit module comprenant:
- une carte à circuit imprimé équipée de composants électroniques, et logée dans un boîtier adaptable au socle,
- un système de raccordement de la carte coopérant par embrochage avec le connecteur du bus,
- et un connecteur bornier auxiliaire pour la liaison de la carte avec un câblage extérieur d'une installation industrielle.

Dans un dispositif connu du genre mentionnée, le boîtier du module électronique comprend un fourreau métallique individuel de forme parallélépipédique solidarisé au socle par des vis de fixation. L'enfichage correct de la carte nécessite des moyens de centrage du fourreau par rapport au connecteur fixe du bus.

Le FR-A-2 412 224 décrit un dispositif de connexion comportant une carte à circuit imprimé pourvue de contacts mâles et montée dans un système de support constitué par deux glissières, un connecteur avant et un connecteur arrière.

L'invention a pour but de faciliter l'embrochage de la carte sur le bus et le connecteur bornier.

Selon l'invention le boîtier du module électronique est composé de deux parties élémentaires séparables de formes conjuguées servant respectivement de support l'une au connecteur bornier, l'autre à la carte, l'assemblage des deux parties s'effectuant lors du raccordement électrique de la carte avec une barrette de connexion du connecteur bornier.

Selon une caractéristique de l'invention, le connecteur bornier est agencé au voisinage de la face avant du boîtier à l'opposé du connecteur du bus et la barrette de connexion coopère avec des languettes de contact de la carte lors de l'assemblage des deux parties et de l'enfichage du module dans le connecteur du bus.

Selon une autre caractéristique de l'invention, la barrette de connexion est équipée d'une pluralité de contacts à insertion orientés vers l'intérieur du boîtier. Un support de bornes de raccordement extérieur est juxtaposé à la barrette de connexion en faisant saillie vers l'extérieur du boîtier. Une goulotte est agencée sur l'une des parties du boîtier pour le logement de la filerie raccordée au support de bornes de raccordement extérieur.

Selon un développement de l'invention, le boîtier du module est doté d'une ouverture permettant l'embrochage d'un barreau test sur un connecteur test auxiliaire de la carte.

D'autres avantages et caractéristiques ressortiront plus clairement de l'exposé qui va suivre de deux modes de mise en œuvre de l'invention, donnés à titre d'exemples non limitatifs et représentés aux dessins annexés, dans lesquels:

la fig. 1 est une vue schématique en perspective de deux modules selon l'invention, celui de gauche étant en position débrochée, et celui de droite en position embrochée;

la fig. 2 est une vue en coupe horizontale d'un module en position embrochée;

la fig. 3 est une vue analogue à celle de la fig. 1, d'une variante de réalisation.

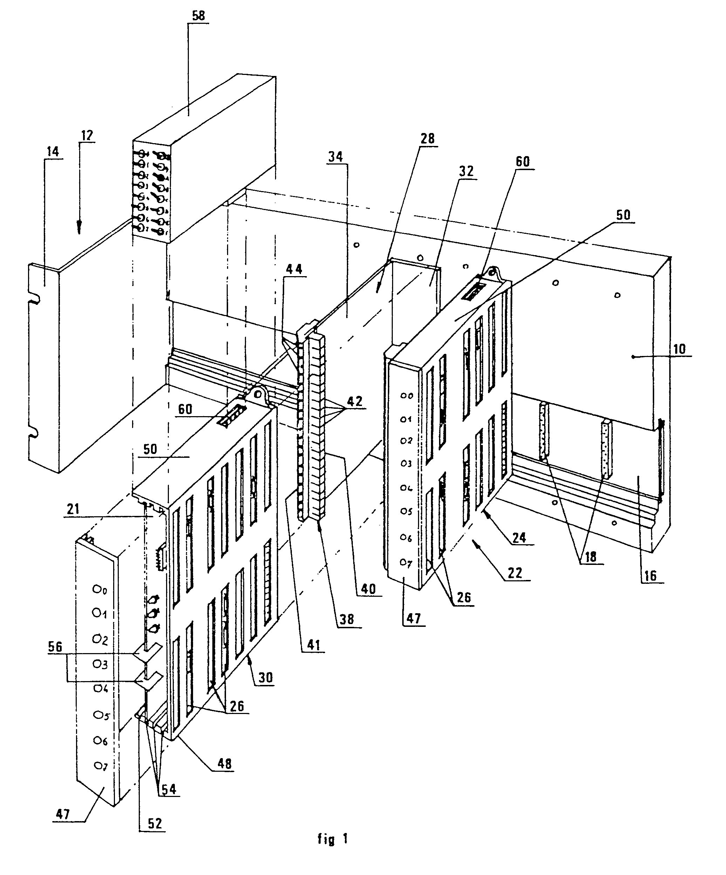

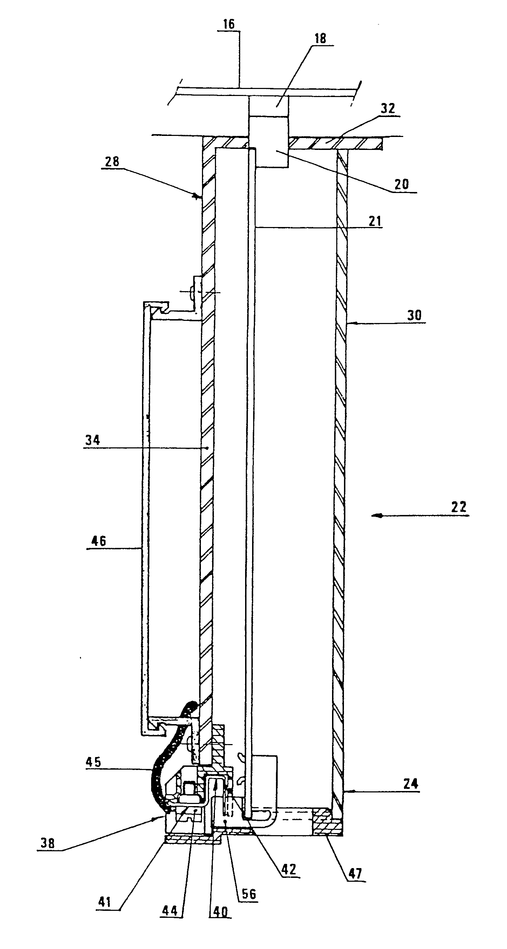

Sur les fig. 1 et 2, un dispositif d'automatisme programmable comporte un socle 10 constitué par un profilé support solidarisé soit à un panneau (non représenté), soit à un rack 12 à flasques 14 latéraux. Au socle 10 est assujettie une carte de liaison 16 ou circuit bus formé par une plaquette à circuit imprimé sur lequel sont échelonnés à intervalles réguliers une pluralité de connecteurs 18 fixes reliés électriquement à des points de branchement prédéterminés du bus 16. Chaque connecteur 18 du bus 16 coopère par embrochage avec un système de raccordement conjugué ou connecteur 20 solidaire d'une carte 21 d'un module électronique 22 enfichable. Le bus 16 comporte autant de connecteurs 18 fixes qu'il y a de modules 22, et les connecteurs 18, 20 sont dotés d'éléments de contacts à insertion femelle-mâle, ou mâle-femelle. Le socle 10 sert également de blindage arrière au bus 16.

Les composants électroniques sont montés sur les cartes 21 des modules 22 enfichables, et le bus 16 est dépourvu de composants en assurant l'interconnexion des cartes 21 à circuits imprimés. En position embrochée, la carte 21 de chaque module 22 est logée dans un boîtier 24 métallique de forme parallélépipédique dont l'une des faces latérales est munie de lumières 26 pour l'évacuation de la chaleur engendrée à l'intérieur du boîtier 24. Ce dernier sert également de protection mécanique, et de blindage électromagnétique de la carte.

Le boîtier 24 métallique de chaque module 22 d'entrée et de sortie de l'automate est formé par l'assemblage de deux parties 28, 30 élémentaires fixées l'une à l'autre lors de l'insertion de la carte 21 dans le connecteur 18 correspondant du bus 16. L'une 28 des parties présente un profil en L fixé par son flanc arrière 32 au socle 10, l'autre flanc 34 en équerre constituant l'une des faces latérales du boîtier 24. Le flanc 32 arrière présente une fenêtre (non représentée) ou est partiellement découpé pour autoriser l'accès au connecteur 18 du bus 16. La partie frontale antérieure du flanc 34 porte un connecteur bornier 38 auxiliaire destiné au raccordement électrique extérieur de l'installation industrielle avec la carte 21, notamment pour l'acquisition des données et la transmission des ordres élaborés par l'unité de commande selon qu'il s'agit d'un module d'entrée ou de sortie, respectivement.

L'expression «connecteur bornier» désignera ci-après un connecteur équipé de bornes.

Le connecteur bornier 38 de chaque module 22 s'étend verticalement dans le sens de la hauteur du boîtier 24 et comporte une barrette de connexion 40 juxtaposée à un support 41 de bornes de raccordement extérieur. La barrette de connexion 40 fait saillie vers l'intérieur du boîtier 24 et est équipée de contacts femelles 42 à insertion pour la liaison avec le circuit imprimé de la carte 21. Le support 41 de bornes de raccordement extérieur fait saillie vers l'extérieur du flanc 34 et comprend une pluralité de bornes 44 latérales susceptibles de recevoir les câbles 45 de raccordement extérieur. La filerie est logée dans une goulotte 46 verticale agencée le long de la face externe du flanc 34. Les bornes 44 du support 41 de bornes de raccordement extérieur peuvent être d'un type quelconque, notamment à vis, à broches, à clips ou à ressort de serrage conformé en cage.

L'autre partie 30 du boîtier 24 comporte la face avant 47 et un fourreau 48 de support de la carte 21. Le fourreau 48 est un profilé extrudé ou moulé en forme de U dont les petites faces 50, 52 transversales opposées supérieure et inférieure sont dotées de rainures 54 internes de positionnement et de guidage de la carte 21. La face latérale du fourreau 48 sert à l'évacuation de la chaleur par les lumières 26.

A l'opposé du connecteur 20, le circuit imprimé de chaque carte 21 est équipé d'une pluralité de languettes d'embrochage 56 à contacts mâles venant en prise avec les contacts femelles 42 correspondants de la barrette de connexion 40 lors de l'insertion de la carte 21 électronique dans le connecteur 18 approprié du bus 16.

Un barreau test 58 peut être associé à chaque module 22 dont la face supérieure 50 du boîtier 24 est munie d'une ouverture 60 permettant l'embrochage vertical du barreau test 58 sur un connecteur test auxiliaire de la carte 21. En position embrochée, le barreau test 58 est superposé au module 22 dont l'encombrement du boîtier 24 dans le sens de la largeur et de la profondeur correspond sensiblement à celui du barreau test 58.

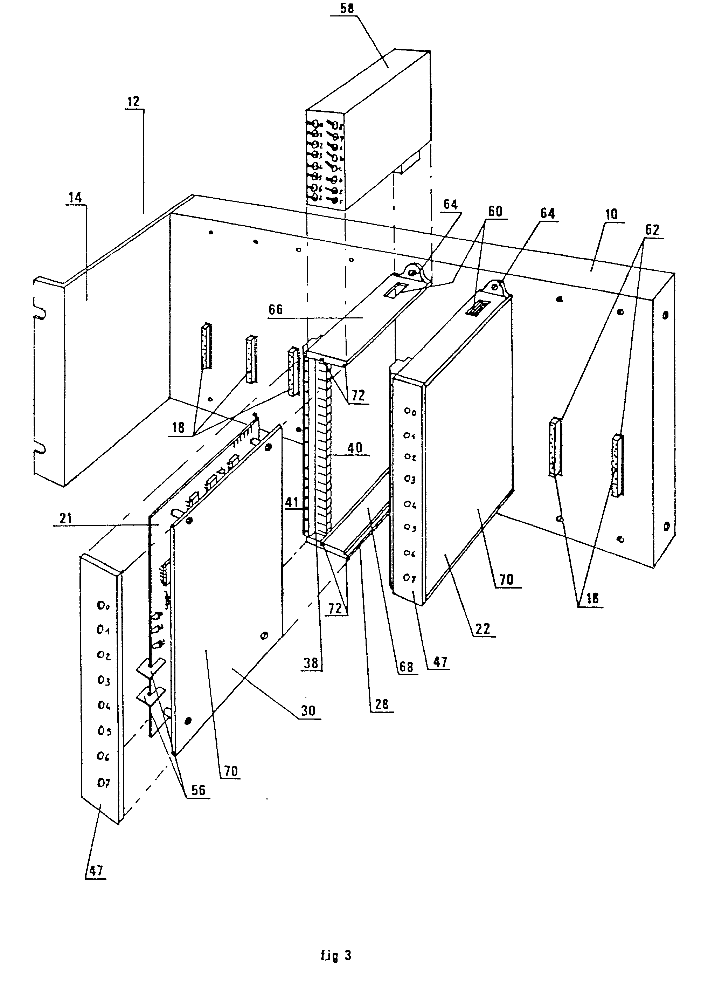

Selon la variante de réalisation illustrée à la fig. 3, les mêmes repères désignent des pièces analogues ou similaires qui ne seront plus décrites en détail par la suite. Le circuit bus (non représenté) est situé à l'arrière du socle 10, ou peut être intégré dans ce dernier. Des ouvertures 62 rectangulaires sont ménagées dans le socle 10 pour le passage des connecteurs 18 du bus. La partie 28 du boîtier 24 de chaque module 22 présente une structure pliée en U fixée au socle 10 par des moyens de fixation introduits dans des oreilles 64. Le connecteur bornier 38 est porté par la partie 28 et s'étend verticalement entre les ailes latérales 66, 68 supérieure et inférieure du U au voisinage de la face avant 47. L'aile supérieure 66 du U comporte une ouverture 60 pour l'embrochage du barreau test 58 sur le connecteur test de la carte 21. L'autre partie 30 du boîtier 24 comprend la carte 21 solidarisée à une plaque 70 parallèle décalée dans le sens de la largeur. L'ensemble carte 21 et plaque 70 associée de la partie 30 se glisse à partir de la face avant dans des rainures 72 agencées dans les ailes 66, 68 de la partie 28 du boîtier 24. Au cours de l'assemblage des deux parties 28, 30, les languettes de contact 56

de la carte 21 de chaque module 22 coopèrent par embrochage avec le connecteur bornier 38, et le connecteur 20 postérieur de la carte 21 est enfiché dans le connecteur 18 correspondant du bus.

## Revendications

1. Module électronique enfichable dans un connecteur (18) fixe porté par une carte de liaison ou bus (16) solidaire d'un socle support (10), ledit module (22) comprenant:

   – une carte (21) à circuit imprimé équipée de composants électroniques, et logée dans un boîtier (24) adaptable au socle (10),
   – un système de raccordement (20) de la carte (21) coopérant par embrochage avec le connecteur (18) du bus (16),
   – et un connecteur bornier (38) auxiliaire pour la liaison de la carte (21) avec un câblage extérieur (45) d'une installation industrielle,

   caractérisé par le fait que le boîtier (24) du module électronique (22) est composé de deux parties (28, 30) élémentaires séparables de formes conjuguées servant respectivement de support, l'une (28) au connecteur bornier (38), l'autre (30) à la carte (21), l'assemblage des deux parties (28, 30) s'effectuant lors du raccordement électrique de la carte (21) avec une barrette de connexion (40) du connecteur bornier (38).

2. Module électronique enfichable selon la revendication 1, caractérisé par le fait que le connecteur bornier (38) est agencé au voisinage de la face avant du boîtier (24) à l'opposé du connecteur (18) du bus (16) et en ce que la barrette de connexion (40) coopère avec des languettes de contact (56) de la carte (21) lors de l'assemblage des deux parties (28, 30) et de l'enfichage du module (22) dans le connecteur (18) du bus (16).

3. Module électronique enfichable selon la revendication 2, caractérisé par le fait que la barrette de connexion (40) du connecteur bornier (38) est équipée d'une pluralité de contacts à insertion (42) orientés vers l'intérieur du boîtier (24) à partir de la face latérale (34) de la partie (28) servant de support au connecteur bornier.

4. Module électronique enfichable selon la revendication 3, caractérisé par le fait que les languettes de contact (56) s'étendent transversalement au circuit imprimé de la carte (21) à l'opposé du système de raccordement (20) pour venir en prise avec les contacts à insertion (42) de la barrette de connexion (40).

5. Module électronique enfichable selon l'une des revendications 1 à 4, caractérisé par le fait qu'à la barrette de connexion (40) est associé un support (41) de bornes de raccordement extérieur faisant saillie de la face latérale (34) de la partie (28) servant de support au connecteur bornier.

6. Module électronique enfichable selon la revendication 5, caractérisé par le fait qu'une goulotte (46) est agencée sur la partie (28) support du connecteur bornier (38) pour le logement de la filerie (45) raccordée au support (41) de bornes de raccordement extérieur.

7. Module électronique enfichable selon l'une quelconque des revendications 1 à 6, caractérisé par le fait que l'une des parties (28, 30) du boîtier (24) est conformé en fourreau de profil en U comprenant des rainures (54, 72) de positionnement de la carte (21).

8. Module électronique enfichable selon l'une quelconque des revendications 1 à 7, caractérisé par le fait que le boîtier (24) du module (22) est doté d'une ouverture (60) permettant l'embrochage d'un barreau test (58) sur un connecteur test auxiliaire de la carte (21).

## Patentansprüche

1. Elektronischer Modul, einsteckbar in eine feststehende Verbindungsleiste (18), die von einer Verbindungskarte oder einer Sammelschiene (16) getragen wird, die mit einem Trägersockel (10) verbunden ist, wobei der genannte Modul (22) aufweist:

– eine gedruckte Schaltungskarte (21), mit elektronischen Bauteilen ausgerüstet und in einem dem Sockel (10) anpassbaren Gehäuse (24) untergebracht,
– ein Anschluss-System (20) der Karte (21), das durch Einschub mit der Verbindungsleiste (18) der Sammelschiene (16) zusammenarbeitet,
– und eine Hilfsanschlussleiste (38) für die Verbindung der Karte (21) mit einer Aussenverkabelung (45) einer Industrieanlage,
dadurch gekennzeichnet, dass das Gehäuse (24) des elektronischen Moduls (22) aus zwei trennbaren, eine zusammenpassende Form aufweisenden Grundteilen (28, 30) besteht, die jeweils als Träger dienen, das eine (28) für den Klemmenanschluss (38), das andere (30) für die Karte (21), wobei das Zusammenfügen der beiden Teile (28, 30) bei dem elektrischen Anschluss der Karte (21) an einer Anschlussleiste (40) des Klemmenanschlusses (38) erfolgt.

2. Elektronischer, einsteckbarer Modul gemäss Anspruch 1, dadurch gekennzeichnet, dass der Klemmenanschluss (38) in der Nähe der Vorderseite des Gehäuses (24) angeordnet ist, dessen gegenüberliegende Seite die Verbindungsleiste (18) der Sammelschiene (16) trägt, und dass die Anschlussleiste (40) mit Kontaktzungen (56) der Karte (21) zusammenarbeitet beim Zusammenfügen der zwei Teile (28, 30) und Einstecken des Moduls (22) in die Verbindungsleiste (18) der Sammelschiene (16).

3. Elektronischer, einsteckbarer Modul gemäss Anspruch 2, dadurch gekennzeichnet, dass die Anschlussleiste (40) des Klemmenanschlusses (38) mit einer Vielzahl von Einschiebkontakten (42) ausgerüstet ist, zum Innern des Gehäuses (24) gerichtet, von der Seitenwand (34) des Teiles (28) aus, welches als Träger für den Klemmenanschluss dient.

4. Elektronischer, einsteckbarer Modul gemäss Anspruch 3, dadurch gekennzeichnet, dass sich die Kontaktzungen (56) quer zu der gedruckten Schaltung der Karte (21) erstrecken, gegenüber dem Anschluss-System (20), um mit den Einschiebkontakten (42) der Anschlussleiste (40) in Verbindung zu kommen.

5. Elektronischer, einsteckbarer Modul gemäss einem der Ansprüche 1–4, dadurch gekennzeichnet, dass mit der Anschlussleiste (40) ein Träger (41) von Aussenanschlussklemmen verbunden ist, welcher Träger aus der Vorderseite (34) des als Träger für den Klemmenanschluss dienenden Teiles (28) herausragt.

6. Elektronischer, einsteckbarer Modul gemäss Anspruch 5, dadurch gekennzeichnet, dass eine Rinne (46) auf dem Trägerteil (28) des Klemmenanschlusses (38) angebracht ist zur Unterbringung der Drähte (45), die mit dem Träger (41) der Aussenanschlussklemmen verbunden sind.

7. Elektronischer, einsteckbarer Modul gemäss irgendeinem der Ansprüche 1–6, dadurch gekennzeichnet, dass eines der Teile (28, 30) des Gehäuses (24) als U-Profilhülse ausgebildet ist, mit Rillen (54, 72) zum Positionieren der Karte (21).

8. Elektronischer, einsteckbarer Modul gemäss einem der Ansprüche 1–7, dadurch gekennzeichnet, dass das Gehäuse (24) des Moduls (22) mit einer Öffnung (60) versehen ist, die das Einschieben eines Prüfstabes (58) auf eine Hilfs-Prüfverbindungsleiste der Karte (21) ermöglicht.

## Claims

1. Electronic module pluggable into a stationary connector (18) supported by a connection card or a busbar (16) rigidly connected with a support base (10), said module (22) comprising:

– a printed circuit card (21) provided with electronic components and located in a housing (24) adaptable to the base (10),
– a connection system (20) of the card (21) cooperating by introduction with the connector (18) of the busbar (16),
– and an auxiliary terminal connector (38) for the connection of the card (21) with an outer wiring (45) of an industrial installation, characterized by the fact that the housing (24) of the electronic module (22) is constituted of two separable elementary parts (28, 30) of conjugated form provided respectively as support, the one (28) for the screw terminals (38), and the other (30) for the card (21), the assembling of the two parts (28, 30) happening during the electrical connection of the card (21) with the connector bar (40) of the screw terminals (38).

2. Pluggable electronic module according to claim 2, characterized by the fact that the screw terminals (38) are situated near the front side of the housing (24) opposite to the connector (18) of the busbar (16) and that the connector bar (40) cooperates with contact lugs (56) of the card (21) when assembling the two parts (28, 30) and plugging the module (22) into the connector (18) of the busbar (16).

3. Pluggable electronic module according to claim 2, characterized by the fact that the connector bar (40) of the screw terminals (38) is provided with several plug contacts (42) directed to the interior of the housing (24) from the lateral face (34) of the part (28) which supports the screw terminals.

4. Pluggable electronic module according to claim 3, characterized by the fact that the contact lugs (56) extend transversely to the printed circuit of the card (21) opposite to the connection system (20) to get into connection with the plug contacts (42) of the connector bar (40).

5. Pluggable electronic module according to one of the claims 1–4, characterized by the fact that the connection bar (40) is associated with a support (41) of exterior connection terminals, projecting out of the lateral face (34) of the part (28) which supports the screw terminals.

6. Pluggable electronic module according to claim 5, characterized by the fact that a channel (46) is arranged on the part (28) supporting the screw terminals (38) to receive the wiring (45) connected to the support (41) of the exterior connection terminals.

7. Pluggable electronic module according to one of the claims 1–6, characterized by the fact that one of the parts (28, 30) of the housing (24) is a U-Profile-shaped duct comprising grooves (54, 72) to position the card (21).

8. Pluggable electronic module according to one of said claims 1–7, characterized by the fact that the housing (24) of the module (22) is provided with a hole (60) permitting the plugging of a test bar (58) into an auxiliary test connector of the card (21).

fig 1

fig 2

fig 3